# EUROPÄISCHE PATENTSCHRIFT

(11) **EP 4 384 836 B1**
(45) Veröffentlichungstag und Bekanntmachung des Hinweises auf die Patenterteilung: **18.06.2025**
(21) Anmeldenummer: 22800262.2
(22) Anmeldetag: 10.10.2022
(51) Int. Cl.: G01R 31/34

(54) **PRÜFSYSTEM**
TEST SYSTEM
SYSTÈME DE TEST

(30) Priorität: 03.11.2021 DE 102021212377
(43) Veröffentlichungstag der Anmeldung: 19.06.2024
(73) Patentinhaber: Siemens Energy Global GmbH & Co. KG, 81739 München (DE)
(72) Erfinder: ROTTHAUS, Dennis, 44388 Dortmund (DE); SCHOMBIERSKI, Marc, 45475 Mülheim an der Ruhr (DE); ÖZCAN, Oktay, 47475 Kamp-Lintfort (DE)
(86) Internationale Anmeldenummer: PCT/EP2022/078087
(87) Internationale Veröffentlichungsnummer: WO 2023/078645

(56) Entgegenhaltungen:
- ES-A1- 2 713 966
- US-A1- 2007 089 544
- US-A1- 2019 126 486
- US-A1- 2022 397 225

## Beschreibung

Die Erfindung betrifft ein System umfassend ein mit zumindest einer Prüfeinrichtung ausgestattetes Prüffahrzeug, das dazu ausgelegt ist, in den Luftspalt zwischen einem Läufer und einem sich axial erstreckende Blechpaketzähne und zwischen den Blechpaketzähnen angeordnete Kupferstäbe aufweisenden Stator einer elektrischen Maschine, insbesondere eines Generators eingesetzt und geradlinig entlang der Blechpaketzähne des Stators verfahren zu werden, um den Zustand des Stators im Bereich der Innenumfangsfläche und/oder den Zustand des Läufers im Bereich der Außenumfangsfläche unter Verwendung der zumindest einen Prüfeinrichtung zu prüfen.

Der Läufer und der Stator eines Generators einer stationären Gasturbinenanlage werden in regelmäßigen Revisionsintervallen und gegebenenfalls beim Auftreten außergewöhnlicher Ereignisse, wie beispielsweise im Falle eines Lastabwurfs, einer visuellen Prüfung unterzogen, um insbesondere thermische Verfärbungen, mechanische Veränderungen in Form von Kratzern, Schlägen, Teileverschiebungen oder dergleichen, losen Teilen, Fremdkörpern etc. festzustellen und zu orten. Zur Ermöglichung eines visuellen Zugangs wird der Läufer meist aus dem Stator ausgebaut bzw. gezogen. Es folgt eine visuelle Inspektion durch das Prüfpersonal durch Inaugenscheinnahme. Mögliche Befunde werden fotographisch dokumentiert. Erst nach abgeschlossener Prüfung und Bewertung der Prüfergebnisse und gegebenenfalls erforderlicher Reparaturarbeiten kann der Generator wieder zusammengebaut und in Betrieb genommen werden. Das Ziehen des Läufers ist allerdings mit großem Aufwand und hohen Kosten verbunden.

Eine Möglichkeit einer visuellen Inspektion im zusammengebauten Zustand von Stator und Läufer besteht grundsätzlich in der Verwendung eines konventionellen Industrieendoskops. Dies gilt jedoch nicht für Generatoren stationärer Gasturbinenanlagen mit Läuferlängen von mehreren Metern.

Ferner sind mit zumindest einer Prüfeinrichtung ausgestattete Prüffahrzeuge bekannt, die dazu ausgelegt sind, in den Luftspalt zwischen einem Läufer und einem sich axial erstreckende Blechpaketzähne und zwischen den Blechpaketzähnen angeordnete Kupferstäbe aufweisenden Stator einer elektrischen Maschine, insbesondere eines Generators eingesetzt und geradlinig entlang der Blechpaketzähne des Stators verfahren zu werden, um den Zustand des Stators im Bereich der Innenumfangsfläche und/oder den Zustand des Läufers im Bereich der Außenumfangsfläche unter Verwendung der zumindest einen Prüfeinrichtung zu prüfen. Ein solches Prüffahrzeug wird beispielsweise von der Firma ABB unter dem Produktnamen "Air Gas Inspector" angeboten. Als Prüfeinrichtung ist hier ein Kamerasystem vorgesehen, das die visuelle Inspektion von Läufer und Stator ermöglicht. Ein wesentlicher Vorteil besteht darin, dass die Prüfung von Läufer und Stator in großen Teilen automatisiert durchgeführt werden kann. Nachteilig ist hingegen, dass das Prüffahrzeug nach jeder Fahrt in axialer Richtung manuell in Umfangsrichtung versetzt werden muss, bevor die nächste Prüffahrt in axialer Richtung durchgeführt werden kann. Bei vielen Generatoren insbesondere aus dem Industriebereich ist der Einsatz dieser Prüfeinrichtung gar nicht möglich, da der Luftspalt zwischen dem Läufer und dem Stator meist nur über einen einseitigen Zugang auf der 12-Uhr-Position zugänglich ist, weshalb ein manuelles Versetzen des Prüffahrzeugs in Umfangsrichtung nicht möglich ist.

US 2019/126486 Al offenbart ein System umfassend ein mit zumindest einer Prüfeinrichtung ausgestattetes Prüffahrzeug, das dazu ausgelegt ist, in den Luftspalt zwischen einem Läufer und einem sich axial erstreckende Blechpaketzähne und zwischen den Blechpaketzähnen angeordnete Kupferstäbe aufweisenden Stator einer elektrischen Maschine, insbesondere eines Generators eingesetzt und geradlinig entlang der Blechpaketzähne des Stators verfahren zu werden, um den Zustand des Stators im Bereich der Innenumfangsfläche und/oder den Zustand des Läufers im Bereich der Außenumfangsfläche unter Verwendung der zumindest einen Prüfeinrichtung zu prüfen.

Vergleichbares offenbart die US 2007/089544 Al.

Ausgehend von diesem Stand der Technik ist es eine Aufgabe der vorliegenden Erfindung, ein System der eingangs genannten Art zu schaffen, das sich flexibler einsetzten und einfacher handhaben lässt.

Zur Lösung dieser Aufgabe schafft die vorliegende Erfindung ein System der eingangs genannten Art, das dadurch gekennzeichnet ist, dass das System ferner eine in den Luftspalt zwischen dem Läufer und dem Stator einsetzbare, auf dem Stator in Umfangsrichtung verfahrbare Spurwechseleinheit aufweist, umfassend eine Parkkassette, die zur Aufnahme des Prüffahrzeugs ausgelegt ist und in die das Prüffahrzeug in axialer Richtung durch eine Parkkassettenöffnung ein- und ausfahren kann, zumindest eine mit der Parkkassette bevorzugt schwenkbar verbundene, wenigstens einen Motor aufweisende Antriebseinheit, die dazu ausgelegt ist, die Spurwechseleinheit zusammen mit dem in der Parkkassette aufgenommenen Prüffahrzeug in Umfangsrichtung zu bewegen, und eine Steuerung zum Steuern zumindest der Spurwechseleinheit. Bei einem solchen System kann das Prüffahrzeug in der Parkkassette der Spurwechseleinheit temporär geparkt und in diesem geparkten Zustand zusammen mit der Spurwechseleinheit auf dem Stator in Umfangsrichtung verfahren werden. Entsprechend ist ein manuelles Versetzen des Prüffahrzeugs in Umfangsrichtung nach jeder axialen Prüffahrt nicht mehr erforderlich. Zum einen wird hierdurch Zeit eingespart. Zum anderen muss das Bedienpersonal nicht über einen längeren Zeitraum in einer sehr beengten Umgebung verweilen. Darüber hinaus wird ein sehr hoher Automatisierungsgrad erzielt. Im Ergebnis lässt sich die Prüfung schnell, einfach und preiswert durchführen.

Gemäß einer Ausgestaltung der vorliegenden Erfindung weist die Spurwechseleinheit zwei Antriebseinheiten auf, die an in Umfangsrichtung gegenüberliegenden Seiten der Parkkassette positioniert und mit der Parkkassette verbunden sind. Entsprechend wird ein symmetrischer Aufbau mit gleichmäßiger Gewichtsverteilung erzielt, was einer verlässlichen Funktionsweise der Spurwechseleinheit sehr zuträglich ist.

Vorteilhaft weist jede Antriebseinheit zumindest zwei angetriebene Antriebsketten auf. Dank solcher Antriebsketten, die insbesondere an den den Stator kontaktierenden Flächen gummiartiges Material umfassen, können Unebenheiten der Statoroberfläche entlang des Bewegungspfads der Spurwechseleinheit einfach überbrückt werden.

Vorteilhaft ist an der Parkkassette ein Sensor vorgesehen, der die Anwesenheit des Prüffahrzeugs innerhalb der Parkkassette detektiert, insbesondere in Form eines Abstandssensors. Die Steuerung kann somit die Spurwechseleinheit in Bewegung setzen, sobald sie das entsprechende Signal des Abstandssensors erhält, das anzeigt, dass das Prüffahrzeug ordnungsgemäß in der Parkkassette geparkt ist.

Bevorzugt weist die Spurwechseleinheit zumindest einen Sensor auf, der die Lage der Spurwechseleinheit im Raum erfasst, insbesondere in Form eines Gyroskopsensors. Mit einem solchen Sensor lässt sich Lage der Spurwechseleinheit im Raum und in Kenntnis des Aufbaus des Stators entsprechend relativ zum Stator detektieren. Anhand des Signals des Sensors kann die Steuerung beispielsweise feststellen, ob die Spurwechseleinheit zur gewünschten neuen Position verfahren wurde, um die zumindest eine Antriebseinheit dann anzuhalten.

Vorteilhaft weist die Spurwechseleinheit zumindest eine den Bereich vor der Parkkassettenöffnung überwachende Kamera auf. Insbesondere sind zwei Kameras vorgesehen, die im Umfangsrichtung beidseitig der Parkkassettenöffnung positioniert sind. Die zumindest eine Kamera dient dazu, das Ein- und Ausparken des Prüffahrzeugs visuell zu überwachen.

Bevorzugt ist zumindest eine den Bildbereich der zumindest einen Kamera ausleuchtende Beleuchtungseinheit vorgesehen. Insbesondere sind zwei Beleuchtungseinheiten vorgesehen, beispielsweise in Form von LED-Streifen, die benachbart zu der jeweiligen Kamera positioniert sind, insbesondere an den Antriebseinheiten.

Vorteilhaft weist die Spurwechseleinheit Akkumulatoreinheiten weist, die bevorzugt an der zumindest einen Antriebseinheit positioniert ist. Über diese Akkumulatoreinheiten wird die Spurwechseleinheit autark mit Energie versorgt.

Gemäß einer Ausführungsform der vorliegenden Erfindung beträgt die Gesamthöhe der Spurwechseleinheit mit dem in der Parkkassette aufgenommenen Prüffahrzeug, wenn die Spurwechseleinheit auf einen ebenen Untergrund aufgesetzt ist, 19mm oder weniger. Mit einer solchen Gesamthöhe lässt sich das System bei sehr vielen Generatoren einsetzen, womit eine hohe Flexibilität erzielt wird.

Die Spurwechseleinheit ist bevorzugt funkgesteuert.

Das Prüffahrzeug ist vorteilhaft kabelgebunden, da im Luftspalt zwischen Läufer und Stator eine hinreichend gute Funkverbindung nur mit hohem Aufwand sichergestellt werden kann. Darüber hinaus lässt sich das Prüffahrzeug im Falle eines Ausfalls über das Kabel einfach aus dem Luftspalt ziehen und auf diese Weise evakuieren. Bevorzugt ist das Kabel durch eine an einer axialen Endwand der Parkkassette vorgesehene Kabeldurchführöffnung geführt, wodurch ein einfacher Aufbau erzielt wird.

Vorteilhaft sind das Prüffahrzeug und die Spurwechseleinheit, wie es insbesondere von Prüffahrzeugen des Stands der Technik bereits bekannt ist, an ihrer jeweiligen Unterseite mit einer Mehrzahl von Magneten versehen, um das Prüffahrzeug und die Spurwechseleinheit am Stator zu halten, auch wenn diese sich in einer Überkopfposition befinden.

Ferner schafft die Erfindung zur Lösung der eingangs genannten Aufgabe ein Verfahren zur Prüfung einer elektrischen Maschine mit einem Läufer und einem sich axial erstreckende Blechpaketzähne und zwischen den Blechpaketzähnen angeordnete Kupferstäbe aufweisenden Stator unter Verwendung eines Systems nach einem der vorhergehenden Ansprüche, umfassend die Schritte:
a) Einsetzen der Spurwechseleinheit mit dem darin aufgenommenen Prüffahrzeug in den Luftspalt zwischen dem Läufer und dem Stator und Aufsetzen der Anordnung auf den Stator;
b) Geradliniges Verfahren des Prüffahrzeugs in axialer Richtung entlang der Blechpaketzähne des Stators, wobei das Prüffahrzeug unter Einsatz der zumindest einen Prüfeinrichtung den Zustand des Stators im Bereich der Innenumfangsfläche und/oder den Zustand des Läufers im Bereich der Außenumfangsfläche entlang des axialen Verfahrwegs prüft;
c) Parken des Prüffahrzeugs in der Parkkassette der Spurwechseleinheit;
d) Verfahren der Spurwechseleinheit zusammen mit dem darin aufgenommenen Prüffahrzeug in Umfangsrichtung entlang des Stators;
Wiederholen der Schritte b) bis d), insbesondere bis die Spurwechseleinheit in Umfangsrichtung um 360° verfahren wurde.

Weitere Vorteile und Merkmale der Erfindung werden anhand der nachfolgenden Beschreibung unter Bezugnahme auf die beiliegende Zeichnung deutlich. Darin ist
- Figur 1: eine schematische perspektivische Teilansicht eines Stators einer elektrischen Maschine, auf den ein Prüffahrzeug und eine Spurwechseleinheit eines Systems gemäß einer Ausführungsform der vorliegenden Erfindung aufgesetzt sind;
- Figur 2: eine Draufsicht der in Figur 1 dargestellten Anordnung;
- Figur 3: eine vergrößerte Draufsicht der Spurwechseleinheit, wobei die oberen Gehäusewände von Antriebseinheiten der Spurwechseleinheit zu Darstellungszwecken durchsichtig dargestellt sind;
- Figur 4: eine perspektivische Teildraufsicht der Spurwechseleinheit, bei der auch die Oberseite des Gehäuses einer Parkkassette der Spurwechseleinheit, in der das Prüffahrzeug aufgenommen ist, durchsichtig und teilweise offen dargestellt ist; und
- Figur 5: eine schematische Seitenansicht der zu prüfenden Maschine.

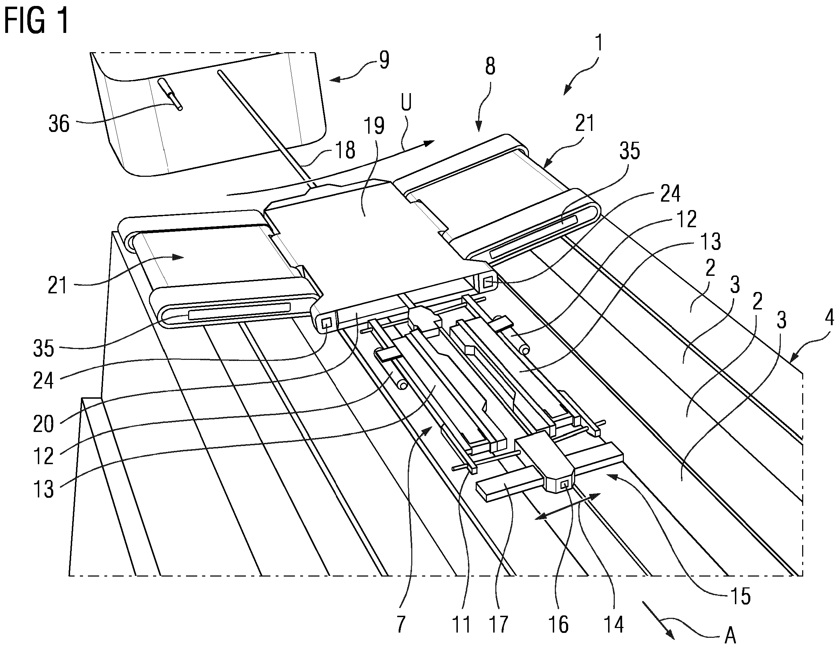

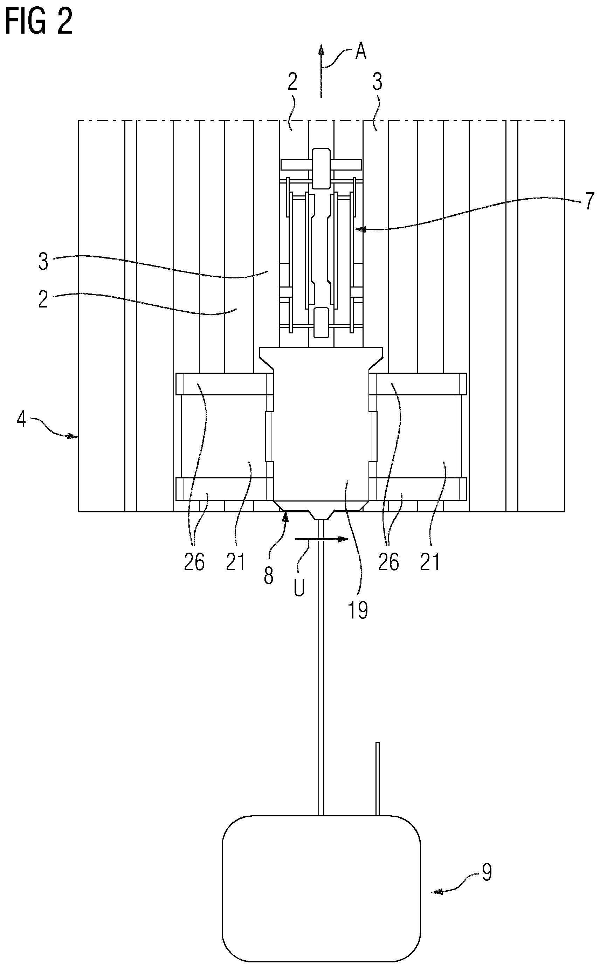

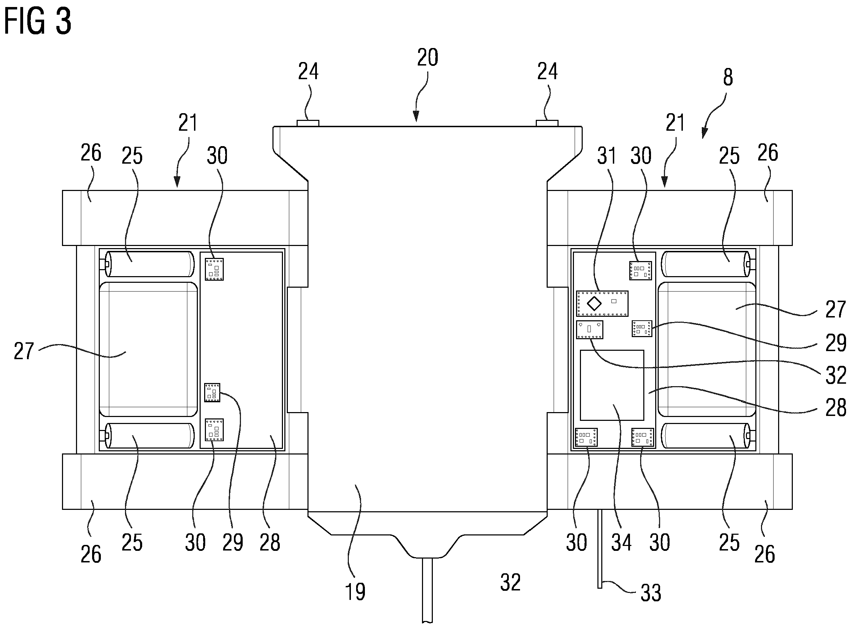

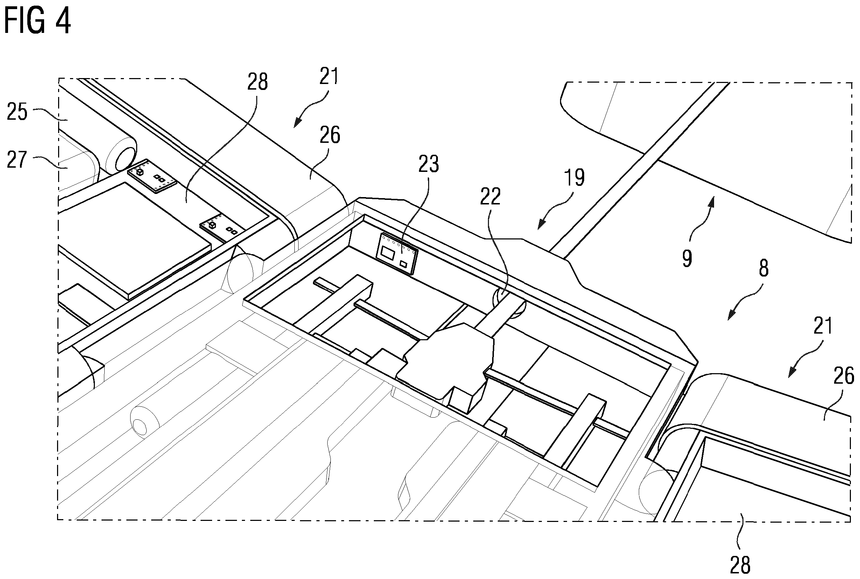

Die Figuren 1 bis 4 zeigen ein System 1 gemäß einer Ausführungsform der vorliegenden Erfindung bzw. Komponenten desselben. Das System 1 dient dazu, den Zustand eines Blechpaketzähne 2 und zwischen den Blechpaketzähnen 2 angeordnete Kupferstäbe 3 aufweisenden Stators 4 und/oder eines Läufers 5 einer elektrischen Maschine 6 zu prüfen, um Beschädigungen zu detektieren, um diese im Anschluss reparieren zu können, wobei es sich bei der elektrischen Maschine 6 vorliegend um einen Generator einer stationären Gasturbinenanlage handelt. Die Hauptkomponenten des Systems 1 sind ein Prüffahrzeug 7, eine Spurwechseleinheit 8 sowie eine Steuerung 9.

Das Prüffahrzeug 7 ist dazu ausgelegt, in den Luftspalt 10 zwischen dem Läufer 5 und dem Stator 4 eingesetzt und geradlinig in axialer Richtung A, entlang der Blechpaketzähne 2 des Stators 4 verfahren zu werden, um den Zustand des Stators 4 im Bereich der Innenumfangsfläche und/oder den Zustand des Läufers 5 im Bereich der Außenumfangsfläche zu prüfen. Das Prüffahrzeug 7 umfasst bei der dargestellten Ausführungsform ein Gestell 11, an dem zwei Elektromotoren 12 gehalten sind, die jeweils eine Antriebskette 13 antreiben. Die Antriebsketten 13 erstrecken sich parallel zueinander und weisen vorliegend an den den Stator 4 kontaktierenden Flächen gummiartiges Material auf oder bestehen aus einem solchen Material. Der Abstand der Antriebsketten 13 ist vorliegend in Richtung des Doppelpfeils 14 variierbar, so dass sich das Prüffahrzeug 7 auf in verschiedenen Abständen voneinander beabstandeten Blechpaketzähnen 2 des Stators 4 der zu prüfenden elektrischen Maschine 6 aufsetzen lässt, wie es in Figur 1 gezeigt ist. An der Unterseite des Gestells 11 sind bevorzugt nicht näher dargestellte Magnete positioniert, wobei die Anzahl, die Positionen und die Stärke der Magneten derart gewählt sind, dass das Prüffahrzeug 7 auch in einer Überkopfposition sicher an dem Stator 4 gehalten ist. Im vorderen Bereich des Gestells 11 ist eine Prüfeinrichtung 15 positioniert, die vorliegend eine Kamera 16 sowie einen Ultraschallsensor 17 umfasst. Von dem hinteren Bereich des Prüffahrzeugs 7 erstreckt sich ein Kabel 18, über welches das Prüffahrzeug 7 strom- und datentechnisch mit der Steuerung 9 verbunden ist. Grundsätzlich kann der Aufbau des Prüffahrzeugs 7 zur Erfüllung des eingangs genannten Zwecks beliebig gestaltet werden. Auch kann die Prüfeinrichtung 15 des Prüffahrzeugs 7 beliebige Sensoren aufweisen, die eine entsprechende Befundung des Stators 4 und/oder Läufers 5 ermöglichen.

Die Spurwechseleinheit 8 ist derart ausgelegt, dass auch sie in den Luftspalt 10 zwischen dem Läufer 5 und dem Stator eingesetzt werden kann. Sie dient dazu, das in erster Linie geradlinig bewegbare Prüffahrzeug 7 in Umfangsrichtung U des Stators 4 zu transportieren. Die Spurwechseleinheit 8 umfasst bei der dargestellten Ausführungsform eine Parkkassette 19, die zur Aufnahme des Prüffahrzeugs 7 ausgelegt ist und in die das Prüffahrzeug 7 in axialer Richtung A durch eine Parkkassettenöffnung 20 ein- und ausfahren kann, sowie zwei an gegenüberliegenden Seiten mit der Parkkassette 19 schwenkbar verbundene Antriebseinheiten 21, die dazu ausgelegt sind, die Spurwechseleinheit 8 zusammen mit dem in der Parkkassette 19 aufgenommenen Prüffahrzeug 7 in Umfangsrichtung U zu bewegen. Die Abmessungen der Parkkassette 19 sind an die Abmessungen des Prüffahrzeugs 7 derart angepasst, dass das Prüffahrzeug 7 durch die Parkkassettenöffnung 20 in die Parkkassette 19 einfahren und darin aufgenommen werden kann. Im hinteren Bereich der Parkkassette 19 ist eine Kabeldurchführöffnung 22 vorgesehen, durch welche das Kabel 18 des Prüffahrzeugs 7 geführt ist. Ferner ist im hinteren Bereich der Parkkassette 19 im Innern derselben ein Sensor 23 vorgesehen, der die Anwesenheit des Prüffahrzeugs 7 innerhalb der Parkkassette 19 detektiert und vorliegend als Abstandssensor ausgebildet ist. Entsprechend kann über den Sensor 23 detektiert werden, ob das Prüffahrzeug 7 ordnungsgemäß in der Parkkassette 19 geparkt ist oder nicht. Im vorderen Bereich der Parkkassette 19 sind benachbart zur Parkkassettenöffnung 20 zwei Kameras 24 positioniert, die den Bereich vor der Parkkassettenöffnung 20 überwachen. Die Antriebseinheiten 21 umfassen jeweils zwei Motoren 25 in Form von Elektromotoren, die zugeordnete, sich parallel zueinander in Umfangsrichtung U des Stators 4 erstreckende Antriebsketten 26 antreiben, die ebenfalls aus einem gummiartigen Material hergestellt sein können. Zwecks Energieversorgung ist jede Antriebseinheit 21 vorliegend mit einer Akkumulatoreinheit 27 versehen. Ferner sind die Antriebseinheiten 27 mit Platinen 28 ausgestattet, auf denen Spannungsregler 29, Motortreiber 30, ein Mikrokontroller 31 und dergleichen positioniert sind. Eine der Platinen 28 ist ferner mit einem Sensor 32 versehen, der die Lage der Spurwechseleinheit 8 im Raum erfasst, vorliegend in Form eines Gyroskopsensors. Darüber hinaus ist auf einer der Platinen 28 eine mit einer Antenne 33 versehene Funkeinheit 34 positioniert, der die datentechnische Verbindung zur Steuerung 9 übernimmt. Zur Ausleuchtung des Bildbereiches der beiden an der Parkkassette 19 positionierten Kameras 24 sind an den jeweiligen Antriebseinheiten 21 Beleuchtungseinheiten 35 vorgesehen, vorliegend in Form von LED-Leuchtstreifen. Die Gesamthöhe der Spurwechseleinheit 8 mit dem in der Parkkassette 19 aufgenommenen Prüffahrzeug 7 beträgt, wenn die Spurwechseleinheit 8 auf einen ebenen Untergrund aufgesetzt ist, vorteilhaft 19 mm oder weniger.

Die Steuerung 9 kommuniziert kabelgebunden mit dem Prüffahrzeug 7 und drahtlos mit der Spurwechseleinheit 8, wozu die Steuerung 9 mit einer Antenne 36 versehen ist. Die kabelgebundene Kommunikation mit dem Prüffahrzeug 7 sichert eine funktionsfähige Datenverbindung in der funktechnisch problematischen Umgebung innerhalb des Luftspalts 10. Zudem kann das Prüffahrzeug 7 durch Ziehen an dem Kabel 18 im Falle einer Fehlfunktion des Prüffahrzeugs 7 in einfacher Weise aus dem Luftspalt 10 geborgen werden.

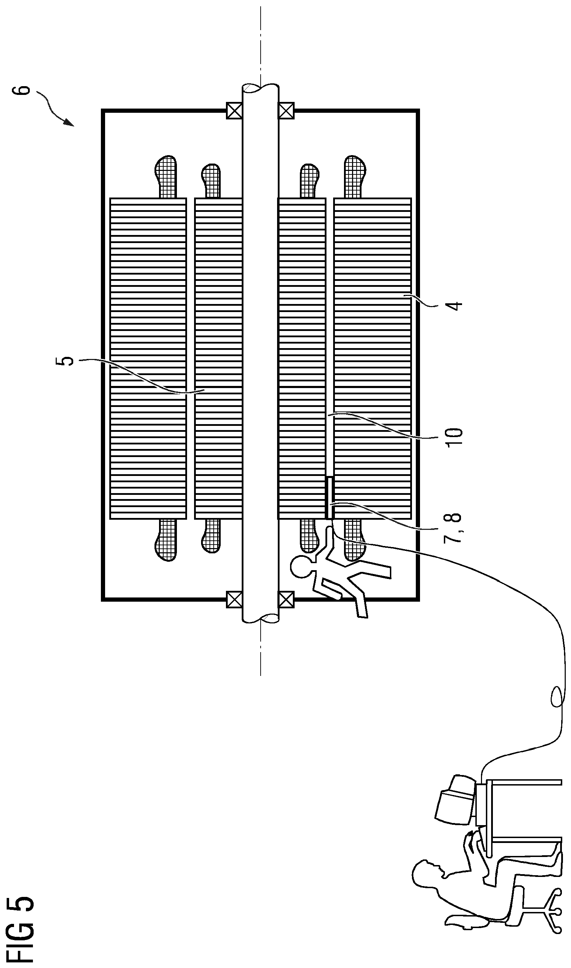

Zur Prüfung der elektrischen Maschine 6 unter Verwendung des zuvor beschriebenen Systems 1 werden unter Bezugnahme auf Figur 5 folgende Schritte durchgeführt. In einem ersten Schritt wird die Spurwechseleinheit 8 mit dem in der Parkkassette 19 aufgenommenen Prüffahrzeug 7 in den Luftspalt 10 zwischen dem Läufer 5 und dem Stator 4 eingesetzt und auf den Stator 4 derart aufgesetzt, dass die Antriebsketten 13 des Prüffahrzeugs 7 mit zwei benachbarten Blechpaketzähnen 2 des Stators 4 fluchten und somit in axiale Richtung A weisen. Die Antriebsketten 26 der Antriebseinheiten 21 der Spurwechseleinheit 8 weisen hingegen in Umfangsrichtung U des Stators 4. In einem weiteren Schritt wird das Prüffahrzeug 7 aus der Parkkassette 19 heraus in axialer Richtung A entlang der Blechpaketzähne 2 des Stators 4 verfahren, wobei das Prüffahrzeug 7 unter Einsatz der Prüfeinrichtung 15 den Zustand des Stators 4 im Bereich der Innenumfangsfläche und/oder den Zustand des Läufers 5 im Bereich der Außenumfangsfläche entlang des axialen Verfahrwegs prüft. Die Sensordaten der Sensoren der Prüfeinrichtung 15 werden dabei über das Kabel 18 an die Steuerung 9 übermittelt. Anschließend wird das Prüffahrzeug 7 axial zurückbewegt und wieder in der Parkkassette 19 der Spurwechseleinheit 8 geparkt. Das ordnungsgemäße Erreichen der Parkposition wird durch den Sensor 23 detektiert und über die Funkeinheit 34 an die Steuerung 9 übermittelt. Nunmehr wird die Spurwechseleinheit 8 zusammen mit dem darin aufgenommenen Prüffahrzeug 7 unter Betätigung der Antriebseinheiten 21 in Umfangsrichtung U entlang des Stators 4 verfahren, bis die Antriebsketten 13 des Prüffahrzeugs 7 axial mit den benachbarten zwei Blechpaketzähnen 2 fluchten, was über die Kameras 24 detektiert und über die Funkeinheit 34 an die Steuerung 9 übermittelt wird. Anschließend folgt eine weitere Prüffahrt des Prüffahrzeugs 7 in axialer Richtung A. Das Verfahren der Spurwechseleinheit 8 und die Prüffahrten 7 des Prüffahrzeugs werden wiederholt, bis die Spurwechseleinheit 8 in Umfangsrichtung U um 360° verfahren und entsprechend eine vollständige Prüfung durchgeführt wurde.

Das zuvor beschriebene System 1 zeichnet sich insbesondere dadurch aus, dass ein manuelles Bewegen des Prüffahrzeugs 7 in Umfangsrichtung U des Stators 4 nach jeder axialen Prüffahrt des Prüffahrzeugs 7 entfällt. So können Personalkosten und Zeit eingespart sowie der Automatisierungsgrad der Prüfung erhöht werden, was eine deutliche Kostensenkung nach sich zieht.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. System (1) umfassend ein mit zumindest einer Prüfeinrichtung (15) ausgestattetes Prüffahrzeug (7), das dazu ausgelegt ist, in den Luftspalt (10) zwischen einem Läufer (5) und einem sich axial erstreckende Blechpaketzähne (2) und zwischen den Blechpaketzähnen (2) angeordnete Kupferstäbe (3) aufweisenden Stator (4) einer elektrischen Maschine (6), insbesondere eines Generators eingesetzt und geradlinig entlang der Blechpaketzähne (2) des Stators (4) verfahren zu werden, um den Zustand des Stators (4) im Bereich der Innenumfangsfläche und/oder den Zustand des Läufers (5) im Bereich der Außenumfangsfläche unter Verwendung der zumindest einen Prüfeinrichtung (15) zu prüfen, **dadurch gekennzeichnet, dass**
das System (1) ferner eine in den Luftspalt (10) zwischen dem Läufer (5) und dem Stator (4) einsetzbare, auf dem Stator (4) in Umfangsrichtung (U) verfahrbare Spurwechseleinheit (8) aufweist, umfassend eine Parkkassette (19), die zur Aufnahme des Prüffahrzeugs (7) ausgelegt ist und in die das Prüffahrzeug (7) in axialer Richtung (A) durch eine Parkkassettenöffnung (20) ein- und ausfahren kann, zumindest eine mit der Parkkassette (19) bevorzugt schwenkbar verbundene, wenigstens einen Motor (25) aufweisende Antriebseinheit (21), die dazu ausgelegt ist, die Spurwechseleinheit (8) zusammen mit dem in der Parkkassette (19) aufgenommenen Prüffahrzeug (7) in Umfangsrichtung (U) zu bewegen, und eine Steuerung (9) zum Steuern zumindest der Spurwechseleinheit (8).

2. System (1) nach Anspruch 1,
**dadurch gekennzeichnet, dass**
die Spurwechseleinheit (8) zwei Antriebseinheiten (21) aufweist, die an in Umfangsrichtung (U) gegenüberliegenden Seiten der Parkkassette (19) positioniert und mit der Parckassette (19) verbunden sind.

3. System (1) nach einem der vorhergehenden Ansprüche,
**dadurch gekennzeichnet, dass**
jede Antriebseinheit (21) zumindest zwei angetriebene Antriebsketten (26) aufweist.

4. System (1) nach einem der vorhergehenden Ansprüche,
**dadurch gekennzeichnet, dass**
an der Parkkassette (19) ein Sensor (23) vorgesehen ist, der die Anwesenheit des Prüffahrzeugs (7) innerhalb der Parkkassette (19) detektiert, insbesondere in Form eines Abstandssensors.

5. System (1) nach einem der vorhergehenden Ansprüche,
**dadurch gekennzeichnet, dass**
die Spurwechseleinheit (8) zumindest einen Sensor (32) aufweist, der die Lage der Spurwechseleinheit (8) im Raum erfasst, insbesondere in Form eines Gyroskopsensors.

6. System (1) nach einem der vorhergehenden Ansprüche,
**dadurch gekennzeichnet, dass**
die Spurwechseleinheit (8) zumindest eine den Bereich vor der Parkkassettenöffnung (20) überwachende Kamera (24) aufweist.

7. System (1) nach Anspruch 6,
**dadurch gekennzeichnet, dass**
zumindest eine den Bildbereich der zumindest einen Kamera (24) ausleuchtende Beleuchtungseinheit (35) vorgesehen ist.

8. System (1) nach einem der vorhergehenden Ansprüche,
**dadurch gekennzeichnet, dass**
die Spurwechseleinheit (8) Akkumulatoreinheiten (27) aufweist, die bevorzugt an der zumindest einen Antriebseinheit (21) positioniert ist.

9. System (1) nach einem der vorhergehenden Ansprüche,
**dadurch gekennzeichnet, dass**
die Gesamthöhe der Spurwechseleinheit (8) mit dem in der Parkkassette (19) aufgenommenen Prüffahrzeug (7), wenn die Spurwechseleinheit auf einen ebenen Untergrund aufgesetzt ist, 19mm oder weniger beträgt.

10. System (1) nach einem der vorhergehenden Ansprüche,
**dadurch gekennzeichnet, dass**
die Spurwechseleinheit (8) funkgesteuert ist.

11. System (1) nach einem der vorhergehenden Ansprüche,
**dadurch gekennzeichnet, dass**
das Prüffahrzeug (7) kabelgebunden ist, wobei das Kabel (18) bevorzugt durch eine an einer axialen Endwand der Parkkassette (19) vorgesehene Kabeldurchführöffnung (22) geführt ist.

12. System (1) nach einem der vorhergehenden Ansprüche,
**dadurch gekennzeichnet, dass**
das Prüffahrzeug (7) und die Spurwechseleinheit (8) an ihrer jeweiligen Unterseite mit einer Mehrzahl von Magneten versehen sind.

13. Verfahren zur Prüfung einer elektrischen Maschine (6) mit einem Läufer (5) und einem sich axial erstreckende Blechpaketzähne (2) und zwischen den Blechpaketzähnen (2) angeordnete Kupferstäbe (3) aufweisenden Stator (4) unter Verwendung eines Systems (1) nach einem der vorhergehenden Ansprüche, umfassend die Schritte:
a) Einsetzen der Spurwechseleinheit (8) mit dem darin aufgenommenen Prüffahrzeug (7) in den Luftspalt (10) zwischen dem Läufer (5) und dem Stator (4) und Aufsetzen der Anordnung auf den Stator (4);
b) Geradliniges Verfahren des Prüffahrzeugs (7) in axialer Richtung (A) entlang der Blechpaketzähne (2) des Stators (4), wobei das Prüffahrzeug (7) unter Einsatz der zumindest einen Prüfeinrichtung (15) den Zustand des Stators (4) im Bereich der Innenumfangsfläche und/oder den Zustand des Läufers (5) im Bereich der Außenumfangsfläche entlang des axialen Verfahrwegs prüft;
c) Parken des Prüffahrzeugs (7) in der Parkkassette (19) der Spurwechseleinheit (8);
d) Verfahren der Spurwechseleinheit (8) zusammen mit dem darin aufgenommenen Prüffahrzeug (7) in Umfangsrichtung (U) entlang des Stators (4);
e) Wiederholen der Schritte b) bis d), insbesondere bis die Spurwechseleinheit (8) in Umfangsrichtung (U) um 360° verfahren wurde.

## Claims

1. System (1) comprising a test vehicle (7) which is equipped with at least one test device (15) and is conceived to be inserted into the air gap (10) between a rotor (5) and a stator (4) of an electric machine (6), in particular of a generator, which stator (4) has axially extending laminated core teeth (2) and copper rods (3) disposed between the laminated core teeth (2), and to be rectilinearly displaced along the laminated core teeth (2) of the stator (4) so as to test the state of the stator (4) in the region of the internal circumferential face and/or the state of the rotor (5) in the region of the external circumferential face while using the at least one test device (15),
**characterized in that**
the system (1) furthermore has a track changeover unit (8) which is insertable into the air gap (10) between the rotor (5) and the stator (4) and is displaceable in the circumferential direction (U) on the stator (4), comprising a parking cassette (19) which is conceived for receiving the test vehicle (7) and which the test vehicle (7) can move into and out of in the axial direction (A) through a parking cassette opening (20), at least one drive unit (21) which is preferably pivotably connected to the parking cassette (19) and has at least one motor (25) and is conceived to move the track changeover unit (8), conjointly with the test vehicle (7) received in the parking cassette (19), in the circumferential direction (U), and a controller (9) for controlling at least the track changeover unit (8).

2. System (1) according to Claim 1,
**characterized in that**
the track changeover unit (8) has two drive units (21) which are positioned on sides of the parking cassette (19) which are mutually opposite in the circumferential direction (U), and are connected to the parking cassette (19).

3. System (1) according to one of the preceding claims,
**characterized in that**
each drive unit (21) has at least two driven drive chains (26).

4. System (1) according to one of the preceding claims,
**characterized in that**
a sensor (23), in particular in the form of a distance sensor, which detects the presence of the test vehicle (7) within the parking cassette (19) is provided on the parking cassette (19).

5. System (1) according to one of the preceding claims,
**characterized in that**
the track changeover unit (8) has at least one sensor (32), in particular in the form of a gyroscopic sensor, which detects the spatial position of the track changeover unit (8).

6. System (1) according to one of the preceding claims,
**characterized in that**
the track changeover unit (8) has at least one camera (24) monitoring the region in front of the parking cassette opening (20).

7. System (1) according to Claim 6,
**characterized in that**
at least one illumination unit (35) illuminating the imaging region of the at least one camera (24) is provided.

8. System (1) according to one of the preceding claims,
**characterized in that**
the track changeover unit (8) has accumulator units (27) which are preferably positioned on the at least one drive unit (21).

9. System (1) according to one of the preceding claims,
**characterized in that**,
when the track changeover unit is placed on a flat surface, the overall height of the track changeover unit (8) including the test vehicle (7) received in the parking cassette (19) is 19 mm or less.

10. System (1) according to one of the preceding claims,
**characterized in that**
the track changeover unit (8) is radio controlled.

11. System (1) according to one of the preceding claims,
**characterized in that**
the test vehicle (7) is tethered, wherein the cable (18) is preferably routed through a cable feedthrough opening (22) provided on an axial end wall of the parking cassette (19).

12. System (1) according to one of the preceding claims,
**characterized in that**
the test vehicle (7) and the track changeover unit (8) on their respective lower side are provided with a plurality of magnets.

13. Method for testing an electric machine (6) having a rotor (5) and a stator (4) which has axially extending laminated core teeth (2) and copper rods (3) disposed between the laminated core teeth (2), while using a system (1) according to one of the preceding claims, said method comprising the following steps:
a) inserting the track changeover unit (8) including the test vehicle (7) received therein into the air gap (10) between the rotor (5) and the stator (4), and placing the assembly onto the stator (4);
b) rectilinearly displacing the test vehicle (7) in the axial direction (A) along the laminated core teeth (2) of the stator (4), wherein the test vehicle (7), while using the at least one test device (15), tests the state of the stator (4) in the region of the internal circumferential face and/or the state of the rotor (5) in the region of the external circumferential face along the axial displacement path;
c) parking the test vehicle (7) in the parking cassette (19) of the track changeover unit (8);
d) displacing the track changeover unit (8), conjointly with the test vehicle (7) received therein, in the circumferential direction (U) along the stator (4);
e) repeating steps b) to d), in particular until the track changeover unit (8) has been displaced by 360° in the circumferential direction (U).

## Revendications

1. Système (1) comprenant un véhicule (7) de contrôle, qui est équipé d'un dispositif (15) de contrôle et qui est conçu pour être inséré dans l'entrefer (10) entre un rotor (5) et un stator (4), ayant des dents (2) de paquet de tôles s'étendant axialement et des barres (3) de cuivre disposées entre les dents (2) de paquet de tôles, d'une machine (6) électrique, en particulier d'un générateur, et pour être déplacé en ligne droite le long des dents (2) du paquet de tôles du stator (4) afin de contrôler, en utilisant le au moins un dispositif (15) de contrôle, l'état du stator (4) dans la partie de la surface périphérique intérieure et /ou l'état du rotor (5) dans la partie de la surface périphérique extérieure,
**caractérisé en ce que**
le système (1) a en outre une unité (8) de changement de voie pouvant être insérée dans l'entrefer (10) entre le rotor (5) et le stator (4), pouvant être déplacée sur le stator (4) dans la direction (U) périphérique, et comprenant une cassette (19) de garage, qui est conçue pour la réception du véhicule (7) de contrôle et qui peut être entrée et sortie par une ouverture (20) de cassette de garage dans la direction (A) axiale dans le véhicule (7) de contrôle, au moins une unité (21) d'entraînement, qui comporte au moins un moteur (25) assemblé, de préférence à pivotement, à la cassette (19) de garage et qui est conçue pour déplacer, dans la direction (U) périphérique, l'unité (8) de changement de voie ensemble avec le véhicule (7) de contrôle reçu dans la cassette (19) de garage, et une commande (9) de commande d'au moins l'unité (8) de changement de voie.

2. Système (1) suivant la revendication 1,
**caractérisé en ce que**
l'unité (8) de changement de voie a deux unités (21) d'entraînement, qui sont positionnées sur des côtés opposés dans la direction (U) périphérique de la cassette (19) de garage et qui sont assemblées à la cassette (19) de garage.

3. Système (1) suivant l'une des revendications précédentes, **caractérisé en ce que**
chaque unité (21) d'entraînement a au moins deux chaînes (26) d'entraînement entraînées.

4. Système (1) suivant l'une des revendications précédentes, **caractérisé en ce qu'**
il est prévu, sur la cassette (19) de garage, un capteur (23), qui détecte la présence du véhicule (7) de contrôle dans la cassette (19) de garage, en particulier sous la forme d'un capteur d'écartement.

5. Système (1) suivant l'une des revendications précédentes, **caractérisé en ce que**
l'unité (8) de changement de voie a au moins un capteur (32), qui relève la position de l'unité (8) de changement de voie dans l'espace, en particulier sous la forme d'un capteur gyroscope.

6. Système (1) suivant l'une des revendications précédentes, **caractérisé en ce que**
l'unité (8) de changement de voie a au moins un appareil (24) photographique contrôlant la région devant l'ouverture (20) de la cassette de garage.

7. Système (1) suivant la revendication 6,
**caractérisé en ce qu'**
il est prévu au moins une unité (35) d'éclairage éclairant la zone d'image du au moins un appareil (24) photographique.

8. Système (1) suivant l'une des revendications précédentes, **caractérisé en ce que**
l'unité (8) de changement de voie a des unités (27) d'accumulateur, qui sont positionnées de préférence sur la au moins une unité (21) d'entraînement.

9. Système (1) suivant l'une des revendications précédentes, **caractérisé en ce que**
la hauteur totale de l'unité (8) de changement de voie avec le véhicule (7) de contrôle reçu dans la cassette (19) de garage, lorsque l'unité de changement de voie est posée sur un sous-sol plan, est inférieure ou égale à 19 mm.

10. Système (1) suivant l'une des revendications précédentes, **caractérisé en ce que**
l'unité (8) de changement de voie est commandée par radio.

11. Système (1) suivant l'une des revendications précédentes, **caractérisé en ce que**
le véhicule (7) de contrôle est relié par câble, dans lequel le câble (18) passe de préférence dans une ouverture (22) de passage de câble prévue sur une paroi d'extrémité axiale de la cassette (19) de garage.

12. Système (1) suivant l'une des revendications précédentes, **caractérisé en ce que**
le véhicule (7) de contrôle et l'unité (8) de changement de voie sont pourvus à leur côté inférieur respectif d'une pluralité d'aimants.

13. Procédé de contrôle d'une machine (6) électrique ayant un rotor (5) et un stator (4) comportant des dents (2) de paquet de tôles s'étendant axialement et des barres (3) de cuivre disposées entre les dents (2) du paquet de tôles, en utilisant un système (1) suivant l'une des revendications précédentes, comprenant les stades :
a) insertion de l'unité (8) de changement de voie avec le véhicule (7) de contrôle, qui y est reçu dans l'entrefer (10) entre le rotor (5) et le stator (4) et pose de l'agencement sur le stator (4) ;
b) déplacement en ligne droite du véhicule (7) dans la direction (A) axiale le long des dents (2) du paquet de tôles du stator (4), dans lequel le véhicule (7) de contrôle contrôle, le long du chemin de déplacement axial, en utilisant le au moins un dispositif (15) de contrôle, l'état du stator (4) dans la partie de la surface périphérique intérieure et /ou l'état du rotor (5) dans la partie de la surface périphérique extérieure ;
c) garage du véhicule (7) de contrôle dans la cassette (19) de garage de l'unité (8) de changement de voie ;
d) déplacement dans la direction (U) périphérique le long du stator (4) de l'unité (8) de changement de voie ensemble avec le véhicule (7) de contrôle, qui y est reçu ;
e) répétition des stades b) à d), en particulier jusqu'à avoir déplacé l'unité (8) de changement de voie de 360° dans la direction (U) périphérique.
